# EUROPEAN PATENT APPLICATION

(11) **EP 2 317 545 A1**
(43) Date of publication of application: **04.05.2011**
(21) Application number: 09174693.3
(22) Date of filing: 30.10.2009
(51) Int. Cl.: H01L 21/67, B65G 49/00

(54) **Substrate transport system and method**

(71) Applicant: Applied Materials, Inc., Santa Clara, CA 95054 (US)
(72) Inventor: Schaefer, Michael, 63674, Altenstadt (DE); Bergmann, Tobias, 63755, Alzenau (DE); Hoffmann, Josef, 63839, Kleinwallstadt (DE); Sauer, Andreas, 65762, Grossostheim (DE); Henrich, Juergen, 63694, Limeshain (DE); Geiss, Andreas, 63452, Hanau (DE)
(74) Representative: Zimmermann, Gerd Heinrich

(57) **Abstract**

A substrate transport system adapted for transporting a substrate moving in a substrate transport direction in a processing chamber is provided. The substrate transport system includes a plurality of transport rollers each having a transport shaft and a transport wheel. The transport shaft and the transport wheel are adapted for supporting the moving substrate. A heating means is arranged between the position of the moving substrate and the transport shaft and is adapted for heating the moving substrate.

## Description

### TECHNICAL FIELD OF THE INVENTION

Embodiments of the present invention relate to a substrate transport system for transporting a moving substrate in a substrate transport direction. In particular, embodiments of the present invention relates to a substrate transport system applied in a surface treatment process where a substrate is transported through at least one substrate processing chamber in the substrate transport direction. Furthermore the embodiments of the present invention relate to a method for transporting a substrate moving in substrate transport direction within a substrate processing chamber.

### BACKGROUND OF THE INVENTION

Surface treatment, surface coating, surface activation/passivation and other surface-related processes are the basis for many thin film, etching and surface activation technologies. As one example, plasma-assisted surface processes provide a powerful tool for activating and/or coating and/or etching a variety of substrates. During these plasma processes the substrate may be moved through an appropriate processing chamber, i.e. the substrate may enter the processing chamber at an insertion aperture, and may leave the processing chamber at an ejection aperture. During its travel through the processing chamber the moving substrate may be heated in order to provide an appropriate surface treatment of the moving substrate.

Furthermore substrates to be processed may be large in size, e.g. they may have widths of up to several meters, such as 1 to 4 meters, in a dimension perpendicular to the substrate transport direction, and may have a length in transport direction of several meters, e.g. up to 6 meters while traveling through the processing chamber.

Heating sources such as heating plates, heating wires, etc. may have an influence on the mechanical components of a substrate transport system. Heat transfer from a heated substrate which moves through the processing chamber, to mechanical components such as transport rollers, bearings, etc. is an issue to be considered.

Material expansion occurs on the basis of a thermal expansion coefficient of the respective material such that problems might arise with respect to a relative adjustment of the individual mechanical components with respect to each other and with respect to a drive system.

Further, uniform heating is desirable for stress reduction of the substrates. A maximum heat transfer from a heater to the substrate is desirable, especially, in light of providing a "green" manufacturing facility, i.e. a facility that reduces energy consumption in order to save environmental resources.

One or more of the above needs should nevertheless be combined with good product manufacturing capabilities of a tool or system.

### SUMMARY OF THE INVENTION

In light of the above, a substrate transport system for transporting a substrate moving in a substrate transport direction in a substrate processing chamber according to independent claim 1 and a method for transporting a substrate moving in a substrate transport direction within a substrate processing chamber according to independent claim 12 are provided.

According to one embodiment a substrate transport system adapted for transporting a substrate moving in a substrate transport direction in a processing chamber is provided, the substrate transport system including a plurality of transport rollers each having a transport shaft and a transport wheel and being adapted for supporting the moving substrate; and a heating means arranged between the position of the moving substrate and the transport shaft and being adapted for heating the moving substrate. According to a further embodiment a substrate transport system adapted for transporting a substrate moving in a substrate transport direction in a processing chamber is provided, the substrate transport system including a plurality of transport rollers each having a transport shaft and a transport wheel and being adapted for supporting the moving substrate; and at least one bearing adapted for rotatably supporting the transport shaft, wherein the transport rollers are configured with at least one heat conductivity reducing means adapted for reducing a heat transfer from the moving substrate to the roller bearing.

According to yet a further embodiment a method for transporting a substrate moving in a substrate transport direction within a processing chamber is provided, the method including moving the substrate into the processing chamber; transporting the substrate on transport rollers having a transport shaft and a transport wheel, in the substrate transport direction, through the processing chamber; heating the substrate by means of at least one heating means positioned between the substrate and the transport shaft; and moving the substrate out of the processing chamber.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:
Figure 1 shows a schematic side view of a substrate transport system adapted for transporting a substrate in a substrate transport direction, according to a typical embodiment;
Figure 2 is a top view of the substrate transport system shown in FIG. 1, wherein a plurality of transport wheels adapted for supporting the moving substrate are arranged in a comb-like manner, according to another typical embodiment;
Figure 3 illustrates a transport roller including a transport shaft and a transport wheel;
Figure 4 is a sectional view of a main frame rotatably holding part of a substrate transport system which intern holds the moving substrate, viewed from a substrate insertion aperture, according to a typical embodiment;
Figure 5 is a detailed view of a transport roller supporting a moving substrate, according to another typical embodiment;
Figure 6(a) is a side sectional view of a roller bearing having two supporting rollers rotatably holding the transport shaft, according to yet another typical embodiment;
Figure 6(b) is a top view of the roller bearing shown in Figure 6(a);
Figure 7 depicts a bearing block having three roller bearings mounted on it, according to another typical embodiment;
Figure 8 is a side sectional view of a substrate transport system including transport wheels and a heating means for heating the moving substrate, according to yet another typical embodiment;
Figure 9 is a side sectional view of a substrate transport system including a cooling plate and a heating means arranged between the moving substrate and a roller bearing, according to yet another typical embodiment;
Figure 10 is a side sectional view of a substrate transport system including a heating means, a heat radiation plate and a cooling plate which are arranged between the moving substrate and at least one roller bearing, according to yet another typical embodiment;
Figure 11 is a top view of a substrate transport system wherein slots of a heating means are shown, the slots being adapted as feedthrough apertures for a number of transport wheels arranged in a comb-like manner;
Figure 12 is a top view of a substrate transport system wherein the heating means includes different heating areas providing different heating intensities, according to yet another typical embodiment;
Figure 13 is a cross sectional view of a spherical bearing provided for holding one end of a transport shaft of a transport roller; and
Figure 14 is a flowchart illustrating a method for transporting a substrate moving in a substrate transport direction within a substrate processing chamber, according to a typical embodiment.

### DETAILED DESCRIPTION OF THE EMBODIMENTS

Reference will now be made in detail to the various embodiments of the invention, one or more examples of which are illustrated in the figures. Within the following description of the drawings, the same reference numbers refer to same components. Generally, only the differences with respect to individual embodiments are described. Each example is provided by way of explanation of the invention and is not meant as a limitation of the invention. For example, features illustrated or described as part of one embodiment can be used on or in conjunction with other embodiments to yield yet a further embodiment. It is intended that the present invention includes such modifications and variations.

Embodiments described herein refer inter alia to a substrate transport system adapted for transporting a substrate moving in a substrate transport direction in a substrate processing chamber. Within the substrate processing chamber a high temperature transport for a heated substrate may be provided. While moving through the substrate processing chamber a substrate is supported by rollers which are at least partially driven by a drive system. As an example, the substrate processing chamber or substrate treating chamber can be a heating chamber, a deposition chamber, an etching chamber, or the like, wherein the processing can optionally be conduced with a plasma assisted process.

Processes which are applied within the substrate processing chamber may include, but are not limited to, physical vapor deposition (PVD), chemical vapor deposition (CVD), plasma enhanced chemical vapor deposition (PECVD), plasma enhanced surface activation, plasma-assisted sputter deposition, etc.

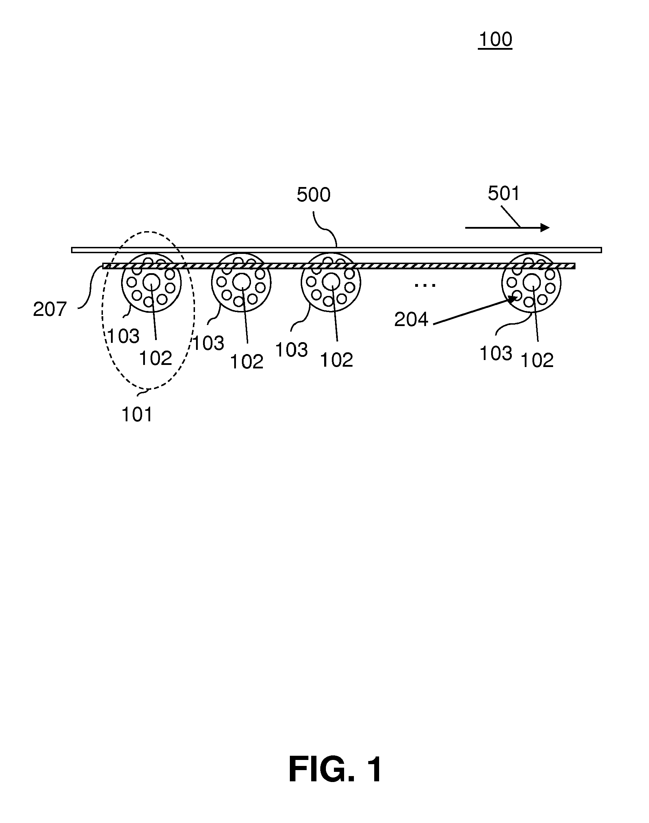

As shown in FIG. 1, and in accordance with embodiments described herein, a treating chamber or a processing chamber, e.g. a plasma processing chamber, may include a substrate transport system 100 having a plurality of transport rollers 101. A transport roller 101 includes a transport wheel 103 which is in direct contact with a surface of a substrate 500 moving in a substrate transport direction 501, and a transport shaft 102 rotatably holding the transport wheel 103. Typically a transport of the substrate 500 should be provided free of scratches, e.g. no visible scratches should be present.

Albeit not shown in FIG. 1, one or more of the transport shafts 102 of the transport wheels 103 may be driven by a drive system such that the substrate 500 may be moved in the substrate transport direction 501 by the action of the drive system.

During a specific process, e.g. during plasma deposition, etching, plasma-enhanced surface modification, plasma-assisted sputtering, etc. the substrate 500 moving in the substrate transport direction 501 may be heated by means of a heating device (not shown in FIG. 1) such that an appropriate substrate temperature may be reached for the specific process. According to a typical embodiment, which can be combined with other embodiments described herein, the substrate transport system 100 thus includes at least one heat conductivity reducing means adapted for reducing a heat transfer from the moving substrate to other components of the substrate transport system 100 such as roller bearings. Thereby, according to different embodiments, which can be combined with other embodiments described herein, the heat transfer from the substrate to the wheel 103, the heat transfer from the wheel 103 to the shaft 102 and the heat transfer from the shaft to the bearing can be reduced by heat conductivity reducing means.

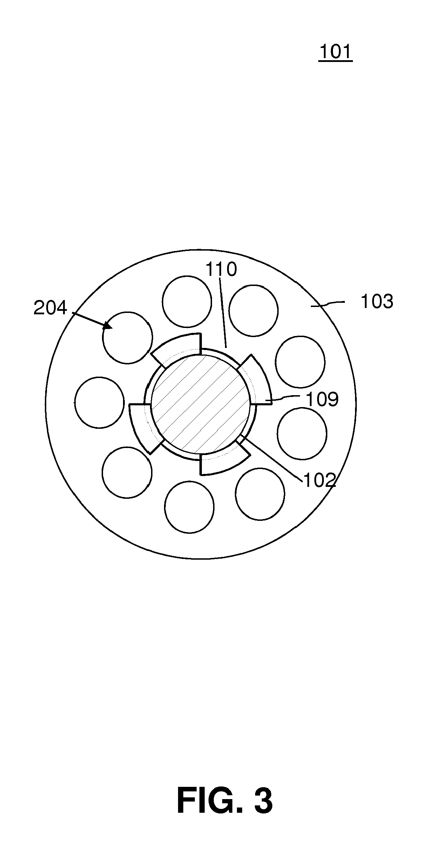

In order to reduce heat transfer from the heated substrate 500 moving in the substrate transport direction 501, to the transport shaft 102 of the transport roller 101 the transport wheel 103 of the transport roller 101 includes, as a first heat conductivity reducing means, at least one heat conductivity reducing aperture 204, as shown herein below in more detail with respect to FIG. 3. It is noted here that the individual components shown in the drawings, especially the components of the transport roller 101, are not drawn to scale with respect to each other. Due to the reduced material mass a heat transfer from the heated substrate 500 to the transport shaft 102 thus is decreased. According to a further embodiment which may be combined with at least one other embodiment described herein a reduction of heat transfer from the heated substrate 500 moving in the substrate transport direction 501 to the transport shaft 102 of the transport roller 101 may be provided by a transport wheel 103 which contains material having a low heat conductivity, e.g. ceramics.

As another heat conductivity reducing means, which can be combined with other embodiments described herein, the edge of the transport wheel, i.e. the circumference of the transport wheel can be shaped to have a reduced contact area with the substrate to be supported. Thereby, the transport wheel can have a conical, a rounded, or a sharp edge.

According to some embodiments, which can be combined with other embodiments described herein, the transport system can be configured to transport a flat substrate like a glass substrate, semiconductor substrates, which may optionally be carried by a carrier, or another substrate.

Furthermore, as shown in the side view of FIG. 1, a cooling plate 207 may be provided as another heat conductivity reducing means, which is arranged between the moving substrate 500 and the axis of the transport roller 101, i.e. between the moving substrate 500 and the transport shaft 102. Water may be flown through the cooling plate 207 in order to further enhance a heat isolation effect. Thereby, radiation heat transfer from the substrate to the transport rollers can be reduced.

Albeit three parallel transport shafts 102 each having transport wheels 103 are shown in FIG. 1, it is noted that an arbitrary number of transport shafts 102 may be arranged side by side. For example, 1 to 20 transport rollers can be provided within one chamber. A heat transfer from the heated substrate 500 to the transport shaft 102 may result in a non-uniform heating of the transport wheel 103 - transport shaft 102 assembly which may be made, at least partially, from stainless steel, e.g. a stainless steel comb roller may be provided. An upper portion of the transport wheel 103 which is in thermal contact with the moving substrate 500 may be heated up to a maximum temperature. This maximum temperature depends on the temperature of a heating means which is described herein below and typically may amount to up to 750 °C. In accordance with one embodiment which can be combined with any of the other embodiments and modifications described herein the heating means may be provided as one element of the group consisting of a heating plate, a heating pipe, an array of heating pipes, and any combination thereof. Moreover an upper part of the transport wheel 103 - transport shaft 102 assembly may be heated by heat radiation emitted by the substrate 500. On the other hand, a lower portion of the transport wheel 103, i.e. a portion at an opposing side of the transport shaft with respect to the substrate position may be cooled by radiation with respect to the cooling plate 207 and/or the walls of the substrate processing chamber having a temperature of typically 50 °C. Thus a corresponding temperature distribution is formed at the transport wheel 103 - transport shaft 102 assembly. As the transport wheel 103 - transport shaft 102 assembly is rotating during substrate transport the temperature distribution correspondingly changes during rotation.

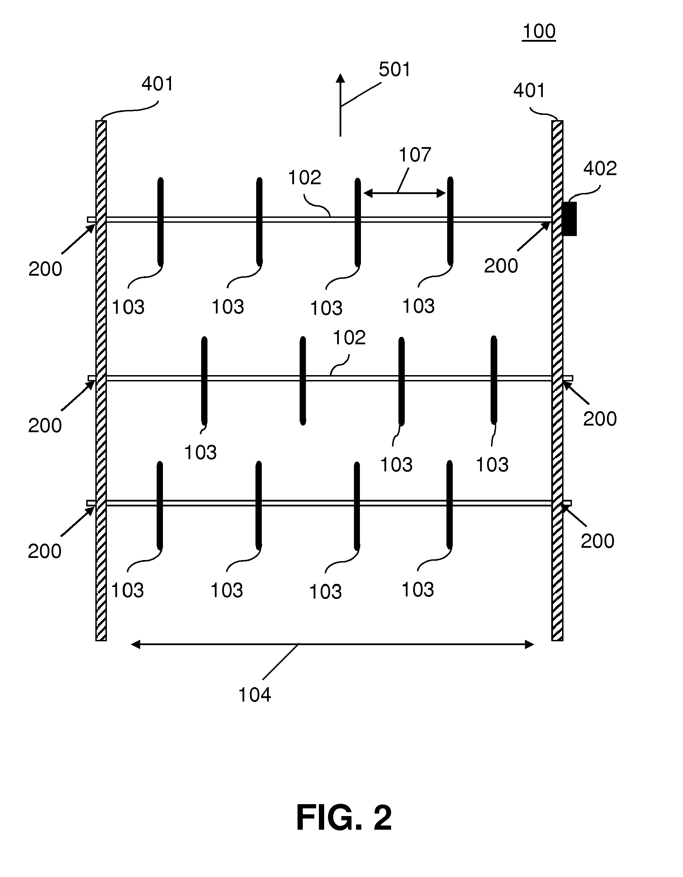

FIG. 2 is a top view of a substrate transport system 100 in accordance with a typical embodiment. Within a main frame 401 which may be installed within a processing chamber, such as a plasma processing chamber, (not shown in FIG. 2) a plurality of transport rollers including at least one transport wheel 103 and a transport shaft 102 are arranged. The axes of the transport shafts 102 may be arranged parallel to each other and perpendicular to the substrate transport direction 501. At least one of the transport shafts 102 may be driven by a driving means 402 which may be arranged outside the substrate processing chamber.

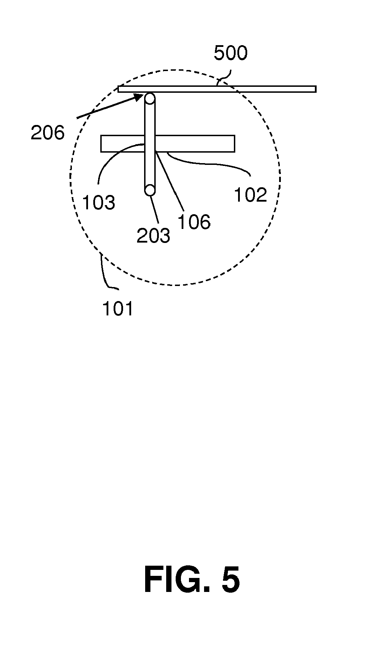

Roller bearings 200 are provided for rotatably supporting the at least one transport shaft 102. The transport shaft 102 may include a plurality of transport wheels 103 which are arranged at predetermined distances with respect to each other. In order to minimize a heat transfer from the moving substrate (not shown in FIG. 2) to the transport shafts 102 and the main frame 401, respectively, the transport wheels 103 which are in direct contact with the moving substrate 500, are designed such that small contact area between the moving substrate 500 and the transport wheel 103 is provided, as will be detailed herein below with respect to FIG. 5.

A double-arrowed line 104 indicates a width of the substrate 500 which moves in the substrate transport direction 501.

In light of the above the transport shaft 102 may need a minimum length in order to allow for transport of large area substrates. Thereby, typically the transport system should be configured for a shaft bending of 1 mm or below. Thus, according to some embodiments, which can be combined with other embodiments described herein, a further bearing support structure (not shown) provided with bearings described in more detail below, can be provided in-between the two main frames 401 in Fig. 2, for example in the middle between the two mainframes.

It is noted here that the mechanical components contacting the moving substrate, i.e. the transport wheels 103, and the mechanical components contacting the transport shaft 102 are designed such that a heat transfer from the moving substrate to the main frame 401 is reduced. Thus a heat load at the transport shaft 102 and the main frame 401, respectively, is reduced.

Thus, the substrate transport system 100 is adapted for moving a substrate in the substrate transport direction 501 within a chamber (not shown in FIG. 2), wherein the substrate transport system 100 includes a plurality of transport rollers 101 each having the transport shaft 102 and the transport wheels 103 and being adapted for supporting the moving substrate, and at least one roller bearing 200 for rotatably supporting the transport shaft 102. The transport rollers each have at least one heat conductivity reducing means, e.g. the heat conductivity reducing apertures 204 (FIG. 1) adapted for reducing a heat transfer from the moving substrate to the roller bearing 200.

According to some embodiments described herein, the transport systems can be configured such that substrates 500 which may be transported using the substrate transport system 100 and which may be processed in the treating or processing chamber may include, but are not restricted to, float glass substrates, low iron content substrates, silicon substrates, etc. wherein the substrates may have a typical size of typically in a range from 1300 mm x 1100 mm x 3-5 mm to 2600 mm x 2200 mm x 3-5 mm. Additionally, or alternatively, typical transport speeds for moving the substrate in the substrate transport direction 501 are in the range from 0.1 m/min to 50 m/min, and typically in a range from 0.9 m/min to 35 m/min, wherein an acceleration of a substrate may amount to approximately 0,5 m/s². Typical temperatures of the substrates 500 to be treated can range from 200 °C to 400 °C, and typically are in a range from 345 °C to 355 °C. According to typical embodiments, which can be combined with other embodiments described herein, the width of the chamber is configured to allow transport of substrates, which are at least 2600 mm x 2200 mm of size. Typical glass sizes can also be 1300 mm x 1100 mm to 2850 mm x 3050 mm, such as for example 2600 mm x 2200 mm.

FIG. 3 is a detailed view of a transport roller 101 which includes a transport shaft 102 and a transport wheel 103. The transport wheel 103 furthermore includes heat conductivity reducing apertures 204 which are provided in order to reduce a heat transfer from the substrate (not shown in FIG. 3) to the transport shaft 102. Furthermore, the transport roller 101 may be provided as a one-piece unit, i.e. the transport shaft 102 and the transport wheel 103 may be formed as an integrated device.

It is noted here that a heat conductivity reducing means can be provided by means of a design of the transport wheel 103 itself. E.g., the transport wheel 103 may include spokes having spaces in between, such that a heat transfer is only possible while the spokes of the transport wheel 103. Moreover the transport wheel 103 may have at least one radial arm holding an annular member which is formed as a wheel.

Further, in accordance with yet another typical embodiment, which can be combined with other embodiments described herein, the transport wheel 103 may be connected to the transport shaft 102 by means of a bayonet nut connector (BNC). As shown in Fig. 3, according to some embodiments a hub connected to the shaft 102 has protrusions 109 and the wheel 103 has corresponding protrusions 110. As indicated by the dotted line the wheel can be rotated with respect to the hub or the shaft, respectively, such that the corresponding protrusions 302 and 303 overlap and can be fixed to each other. On the other hand, the wheel can be rotated after a fixation of the protrusion has been released such that the protrusions 303 are in between the protrusions 302. Thereby, the BNC-type connector has the advantage that an individual transport wheel 103 can be exchanged in a simplified manner. That is the wheels can be all moved to one of the ends of the shaft and can be replaced during maintenance

A yet further effect of the BNC-type connector is the fact that the hub is in thermal contact with the shaft at two or more, e.g., three or four, positions only. Thus, the bayonet type connector reduces the area at which the wheel is in thermal contact with the shaft, i.e., the bayonet type connector act in a similar manner as the spokes mentioned above. Thus, the bayonet type connector acts as a means for reducing thermal conductivity.

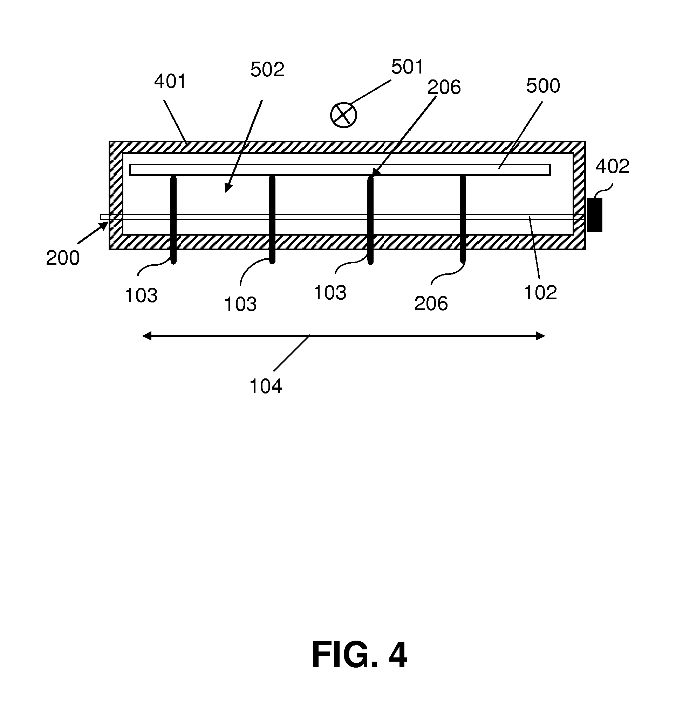

FIG. 4 is a cross sectional view in the transport direction 501 of the substrate 500. A substrate 500 is shown to be supported by means of the transport wheels 103 which may have a convex circumferential wheel surface 203. The convex circumferential wheel surface 203 (see also FIG. 5) provides a reduced contact area 206 between the moving substrate 500 and the transport wheel 103, and thus a reduced heat transfer to the transport shaft 102 and the main frame 401, respectively. According to yet different embodiments, which can be combined with other embodiments described herein, the convex circumferential surface can be rounded, coned shaped, or can be an edge or the like.

The main frame 401 has a substrate insertion aperture 502 through which the substrate 500 may be moved (inserted). The substrate is then supported by the first row of transport wheels 103 arranged at a first (insertion) transport shaft 102 and continues to travel within the main frame 401 in the substrate transport direction 501.

FIG. 5 is a detailed view of a transport roller 101 according to a typical embodiment which may be combined with other embodiments described herein. The transport roller 101 includes the transport wheel 103 and the transport shaft 102. Furthermore the transport roller 101 includes a hub 106 which is used for connecting the transport shaft 102 to the transport wheel 103. The hub is designed such that a reduced heat transfer is provided between the transport wheel 103 and the transport shaft 102.

Furthermore, as can be seen in the cross section shown in FIG. 5, a substrate-wheel contact area 206 is reduced due to a convex shape of the circumferential wheel surface 203 of the transport wheel 103. Thus, by combining two heat conductivity reducing means, i.e. the convex shaped circumferential wheel surface 203 and the low heat conductivity hub 106, a heat transfer from the moving substrate 500 to the transport shaft 102 and, thus, to the roller bearing 200 (not shown in FIG. 5) is reduced.

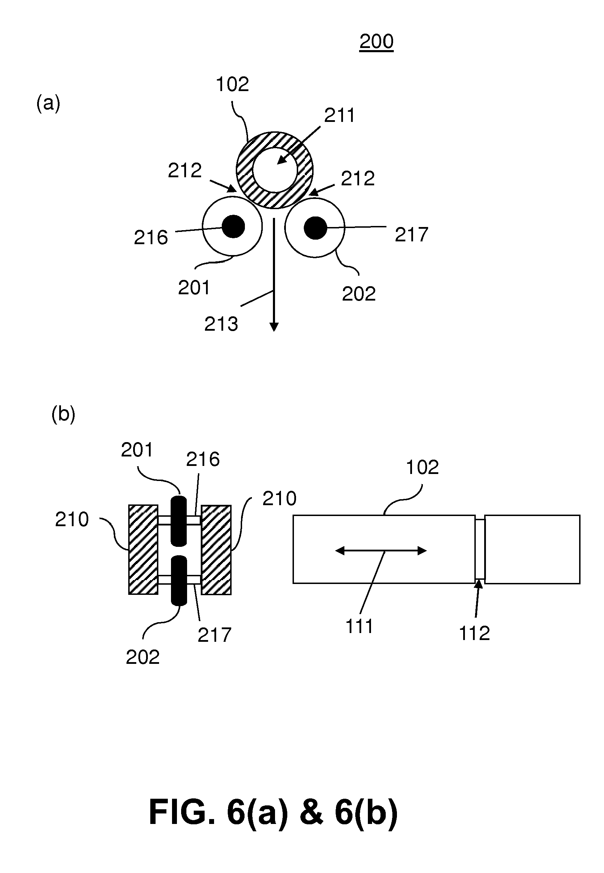

FIG. 6(a) is a cross sectional view of a roller bearing 200 according to another typical embodiment, which can be combined with other embodiments described herein. The roller bearing 200 includes a first supporting roller 201 and a second supporting roller 202 which are arranged adjacent to each other. The first supporting roller 201 is rotatably attached to a first fixed roller shaft 216 and is rotating about the first fixed roller shaft 216 whereas the second supporting roller 202 is rotatably attached to a second fixed roller shaft 217 and is rotating about the second fixed roller shaft 217. The transport shaft 102 is supported by the first and second supporting rollers 201, 202 just by the effect of gravity acting downwards in the direction of an arrow 213. The transport shaft 102 may be provided with a transport wheel 103 which in turn supports the moving substrate (not shown in FIG. 6(a)).

FIG. 6(b) is a top view of the roller bearing 200 shown in FIG. 6(a) the transport shaft 102 being removed. A part of the bearing block 210 is illustrated, too. The first and second roller shafts 216, 217 are fixed at the bearing block 210 and the first and second supporting rollers 201, 202 may rotate about the first and second roller shafts 216, 217, respectively, if the transport shaft is rotatably supported by the first and second supporting rollers 216, 217. The transport shaft 102 may perform a axial shift, with respect to the roller bearing 200, in directions of an arrow 111 such that a floating roller bearing is provided. Furthermore, a fixed bearing may be provided by inhibiting an axial shift 111 of the transport shaft 102 with respect to the roller bearing 200 by means of a circumferential indentation 112 provided at the transport shaft 102. Convex surfaces of the supporting rollers 201, 202 engage with the indentation 112 such that the transport shaft 102 is fixed in an axial direction.

In a roller bearing 200 such as the ones described herein above the support of the transport shaft 102 by means of the first and second supporting rollers 201 and 202, respectively, further reduces a heat transfer from the heated substrate to mechanical components of the transport system. In order to further reduce a heat transfer, the first and second supporting rollers 201 and 202, respectively may have convex circumferential surfaces such as the surface shown with respect to the transport wheel 103 (see FIG. 5). A central roller shaft 211 is exposed to heat transfer from the heating means 300 and the substrate and typically may be heated to reach temperatures of up to 450 °C to 500 °C. Thus heat-loaded components include the central roller shaft 211 - transport wheel 102 assembly. In accordance with a typical embodiment which may be combined with other embodiments described herein a quick and easy replacement of the central roller shaft 211 - transport wheel 102 assembly may be provided using the roller bearing shown in FIG. 6. According to a typical embodiment a diameter of the central roller shaft 211 may be small with respect to a diameter of the transport wheel 102 such that space for the heating means is provided. In addition to that the central roller shaft may be thermally isolated by an appropriate selection of materials. At least one transport shaft 102 may be driven by a driving means 402 (FIG. 2).

Temperatures at the transport shaft 102 typically range from 300 °C to 500 °C, and more typically from 450 °C to 500 °C. Thus, according to some embodiments, which can be combined with other embodiments described herein, the support bearing can be provided by two rollers underlying the shaft. Accordingly, thermal expansion of the transport shaft within a cylindrical bearing, e.g. a ball bearing, does not result in blocking or damage of the bearing by the larger thermal expansion of the transport shaft as compared to the bearing.

Generally, for some of the embodiments described herein, thermal expansion of components should be considered more closely when large area substrates, such as GEN7, GEN9, GEN10 or even larger substrates are to be processed.

As mentioned above, some embodiments may include a center support for supporting the shaft between the bearings at the main frame. A bearing as shown in Fig.2, for which the transport shaft rests upon two rollers can also be used in the middle of the shaft. Thereby, bending of the shaft can be reduced, particularly for large area substrates as referred to above.

According to yet a further option, a hollow shaft may be provided with a ball bearing such that the shaft is outside of the bearing, which might also allow for thermal expansion of the shaft without excessive radial forces on the bearing and a resulting malfunctioning.

According to different embodiments, which can be combined with other embodiments described herein, a typical diameter of the transport wheel 103 is in the range from 150 mm to 200 mm, and typically is about 180 mm; a diameter of the transport shaft 102 is in the range from 30 mm to 50 mm, and typically amounts to about 40 mm; and/or the diameter of the first and second supporting rollers 201 and 202, respectively are in a range from 15 mm to 40 mm, in typically amounts to 30 mm.

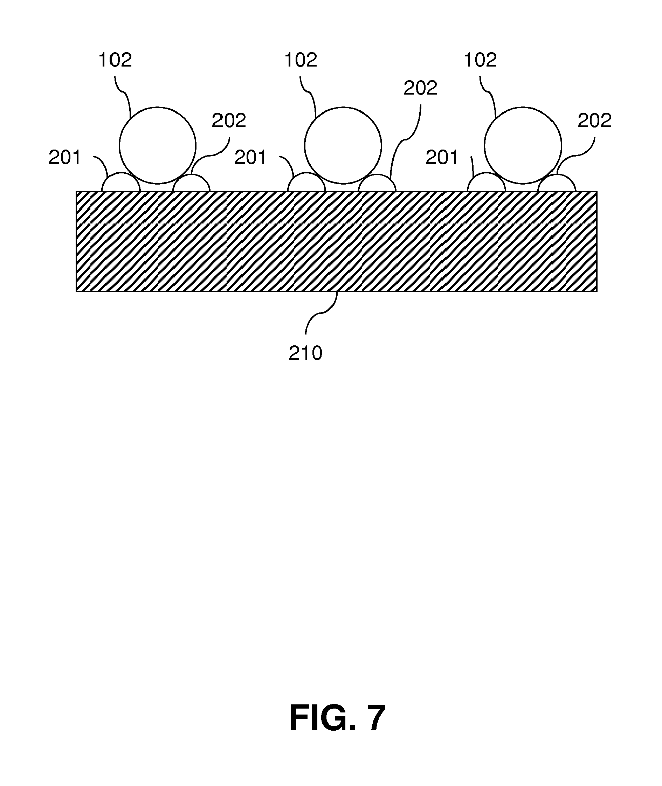

FIG. 7 is a cross sectional view of a bearing block 210 including three roller bearings 200. Each roller bearing has a first supporting roller 201 and a second supporting roller 202, which are rotatably supported by means of the bearing block 210. Albeit three roller bearings 200 are shown to be supported by the bearing block 210 illustrated in FIG. 7, an arbitrary number of roller bearings 200 may be supported by one bearing block 210.

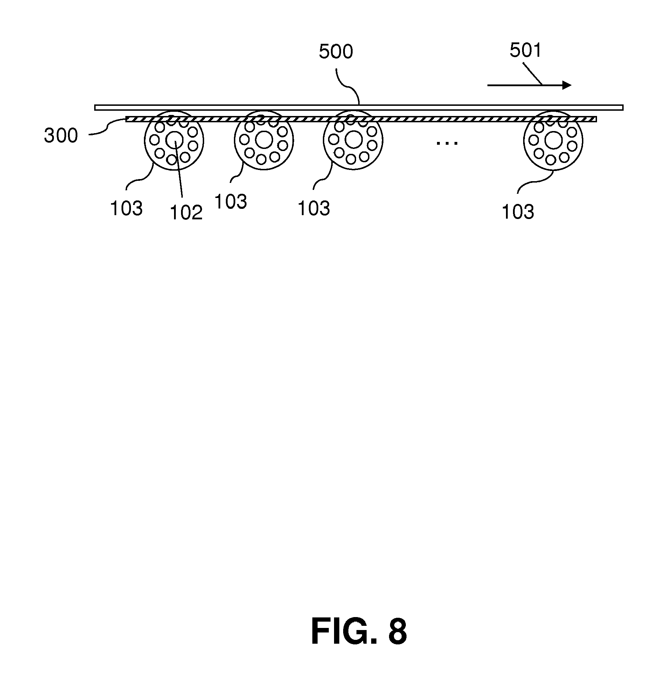

FIG. 8 is a side sectional view of a substrate transport system 100 in accordance with a typical embodiment, which can be combined with other embodiments described herein. The substrate 500 may be conveyed in the substrate transport direction 501 by a rotation of the transport wheels 103. At least one of the transport wheels 103 may be driven by an external driving means 402 (FIG. 2). Between the individual shafts 102 of the transport rollers and the moving substrate 500 the heating means 300 is arranged. In accordance with one embodiment which can be combined with any of the other embodiments and modifications described herein the heating means 300 of FIG. 8 is provided as a heating plate. The heating plate 300 provides a uniform heating of the moving substrate 500. Thus, according to some embodiments, which can be combined with other embodiments described herein, a directed heating of the glass substrate can be provided by arranging heating elements between the shaft and the substrate position. Thereby, heat is directly provided to the substrate without having transport elements between the substrate and a heating element that would commonly be provided below the transport system. Thereby the heated mass is reduced, which reduces maintenance time, since faster cooling of the system can be provided. This effect can be further increased by shielding plates or cooling plates between the heating element and the transport shaft. According to one embodiment which can be combined with other embodiments described herein a temperature of the heating means typically may be in a range of up to 650 °C. In addition to that, or alternatively, a heating means may be provided above the substrate 500, i.e. a heating means may be adapted for heating the substrate 500 to be processed from an upper side, i.e. from a side of the substrate 500 which is opposing the position of the transport wheels.

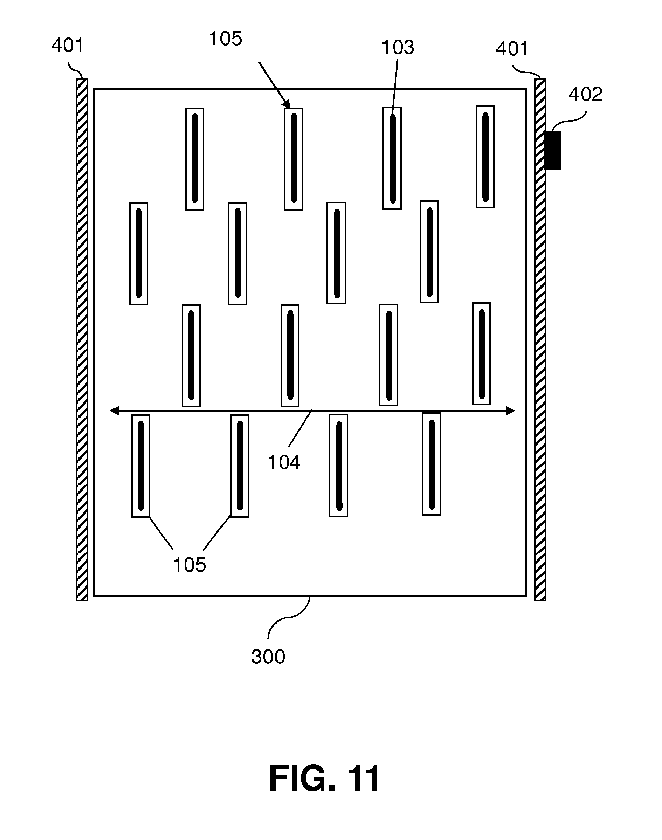

As will be described herein below with respect to FIG. 11, the heating means 300 which is formed as a heating plate has openings such as slit-shaped wheel feedthrough apertures adapted for the transport wheels to reach through the apertures. In this way an individual transport wheel 103 may contact the moving substrate 500.

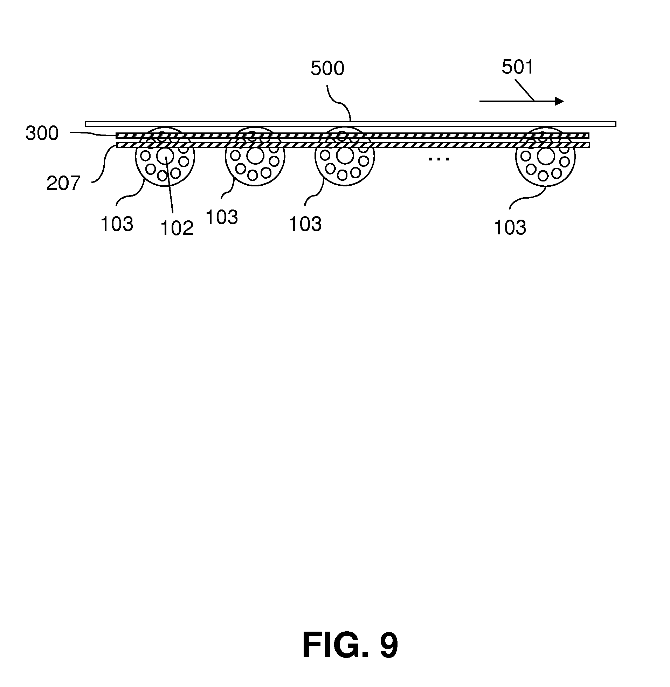

FIG. 9 is another side sectional view of a substrate transport system 100 in accordance with yet another embodiment, which can be combined with other embodiments described herein. As shown in FIG. 9, a cooling plate 207 is arranged between the transport shaft 102 and the heating means 300. The cooling plate 200 provides another heat conductivity reducing means for reducing a heat transfer from the heated substrate 500 to mechanical components of the substrate drive system. While the heating means 300 is adapted for providing an efficient and uniform substrate heating, the cooling plate 207 acts as a heat isolation between the heated substrate 500 and mechanical components arranged below the cooling plate 207, as shown in FIG. 9.

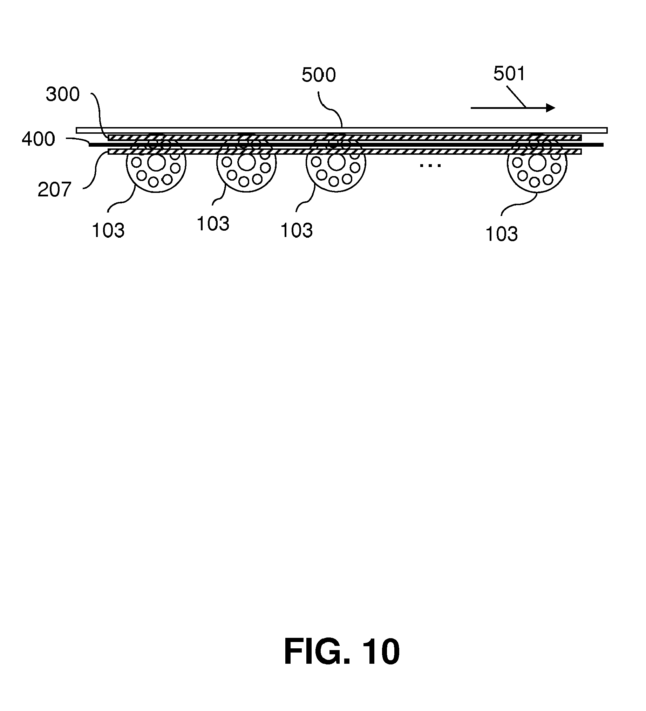

FIG. 10 is a side sectional view of a substrate transport system according to yet another embodiment, which can be combined with other embodiments described herein. In addition to the embodiment described with respect to FIG. 9, the substrate transport system 100 according to FIG. 10 includes a heat radiation plate 400 arranged between the heating means 300 and the cooling plate 207. The heat radiation plate thus provides an even more efficient radiation of heat towards the substrate 500. Again a heat isolation between the heated components (i.e. the heated substrate 500, the heating means 300 and the heat radiation plate 400, and the roller bearing 200) is provided by the cooling plate 207. The cooling plate may include cooling channels through which water may be flown in order to provide an even more efficient cooling. The heat radiation plate 400 furthermore contributes to a reduction of heat transfer from the moving substrate 500 to the roller bearing 200 (not shown in FIG. 10).

Albeit not shown in FIG. 10, more than one heating means 300 and/or more than one heat radiation plate 400 and/or more than one cooling plate 207 may be provided in order to effect the above described heating, heat radiation and cooling. Additional plates may be arranged in a stacked manner above each other.

FIG. 11 is a top view of a substrate transport system 100 according to yet another typical embodiment, which can be combined with other embodiments described herein. A main frame 401 is provided for supporting the transport rollers 101 (see FIG. 3), the transport wheels 103 of which pass through the openings (wheel feedthrough slots, wheel feedthrough apertures) 105 of the heating means (heating plate) 300. The individual transport wheels 103 are fixed at the respective transport shafts 102 (not shown in FIG. 11) such that a comb-like arrangement is obtained as shown in FIG. 11. A leading edge transport shaft 102 is driven by the driving means 402 which is attached at the main frame 401.

In order to reduce stress resulting from thermal material expansion at least one of the bearings of the transport shaft 102 may be provided as a floating bearing, wherein the other bearing may be provided as a fixed bearing.

With respect to the side sectional views shown in FIG. 8, 9 and 10, it is noted here that the respective openings or wheel feedthrough slots 105 are provided in each of the heating means 300, the cooling plate 207 and the heat radiation plate 400 in order to allow the transport wheels 103 to reach through the respective openings 105 such that the moving substrate 500 (not shown in FIG. 11) may be supported.

In light of the above the heaters between the transport shaft and the substrate position, e.g., with having the slit-shaped apertures in the heaters for having the transport wheels pass therethrough allow for good direct thermal heating of the substrate over a large area in a range of 1300 mm x 1100 mm to 2850 mm x 3050 mm, such as for example 2600 mm x 2200 mm. The direct heating over a large area without additional heat sinks in-between a heating element and a substrate can also reduce thermal stress in the substrate, e.g. a glass substrate by an enlarged direct heating area.

If roller bearings 200 such as the ones described with respect to FIG. 6 herein above are used as bearings for the transport shaft 102 of the transport roller 101, the transport shaft 102 together with the transport wheels 103 may be easily exchanged for service and repair work, once the heating means 300 has been removed. In order to provide a uniform heating of the moving substrate the wheel feedthrough slots 105 and the transport wheels, respectively, may have a small thickness, which is configured to the width of the transport wheels.

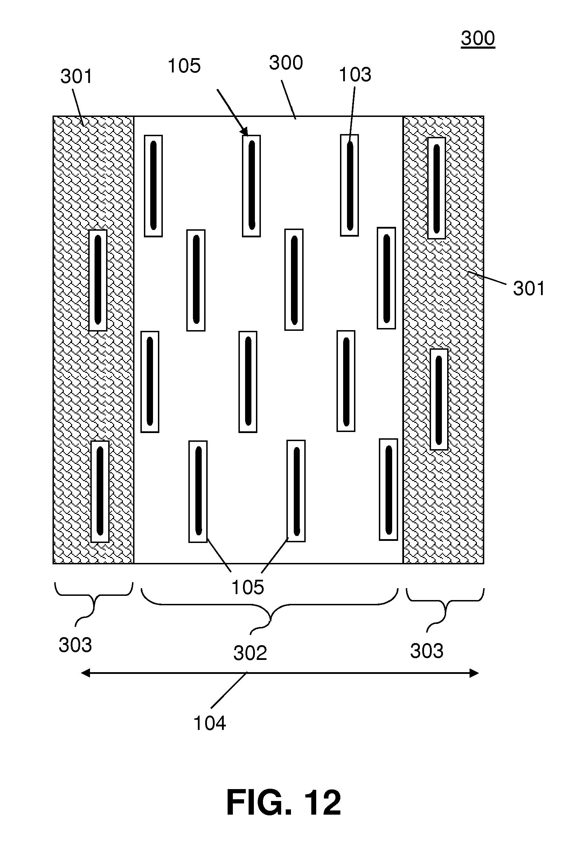

FIG. 12 is a top view of a heating means 300 in accordance with yet another typical embodiment, which can be combined with other embodiments described herein. The heating means 300 shown in FIG. 12 includes different heating areas, i.e. a first heating area 302 and a two second heating areas 303. The first heating area 302 is arranged in a center of the heating means 300, with respect to the substrate width 104 (see FIG. 2). Thus both lateral sections of the moving substrate 500 may be heated using a different heating intensity with respect to the center part of the moving substrate.

In order to achieve additional heating at the lateral sections of the moving substrate 500, a density of heating wires 301 provided at the second heating area 303 is higher than a density of heating wires provided at the first heating area 302. Thus the first heating area 302 has a low density of heating wires, wherein the at least two second heating areas 303 have a high density of heating wires 301. The at least two second heating areas 303, which have a high density of heating wires, are arranged at lateral sides with respect to the substrate transport direction 501 of the heating means 300. The first heating area 302 having a low density of heating wires is located between the two second heating areas 303. Albeit not shown in Fig. 12, according to a further embodiment which may be combined with at least one other embodiment described herein, the second heating areas 303 may be arranged in an orientation perpendicular to the substrate transport direction 501 such that an additional heating is provided at edges of the substrate 500 extending perpendicular to the substrate transport direction 501. Such kind of arrangement perpendicular to the substrate transport direction 501 may allow a compensation of heating nonuniformity due to a discontinuous transport of the substrate 500 in the substrate transport direction 501.

Heat energy loss resulting from cooling the moving substrate at the lateral sides of the substrate by an unheated region, with respect to the transport direction 501, thus may be compensated for by applying the higher heating intensity at the laterals sides compared to the heating intensity applied at the center region of the substrate. Thus the moving substrate 500 may be heated uniformly, with respect to a direction being perpendicular to the substrate transport direction 501. Advantageously, a uniform heating of the moving substrate may increase a uniformity of the applied deposition process, e.g. the uniformity of a thin film deposited onto the substrate by a PVD, a CVD, a plasma assisted process or the like. The heating wires may extend in a direction which is about parallel to the substrate transport direction 501, in a direction which is about perpendicular to the substrate transport direction 501, or in any combination thereof. According to a typical embodiment which may be combined with other embodiments described herein heating wires in a first region of the heating means 300 may extend in a direction about parallel to the substrate transport direction 501 and heating wires in a second region of the heating means 300 may extend in a direction about perpendicular to the substrate transport direction 501 such that moving substrate 500 passes both regions which may result in an even more uniform heating of the substrate 500. According to a yet another typical embodiment which may be combined with other embodiments described herein at least one heating means with an appropriate orientation of heating wires may be arranged at a side of the substrate 500 opposing the substrate surface to be coated, i.e. above the substrate 500 such that both sides of the moving substrate 500 are heated. Furthermore orientations of heating wires arranged at heating means above and below the substrate 500 may extend perpendicular to each other, i.e. may be crossed such that a more uniform heating of the substrate 500 may be provided.

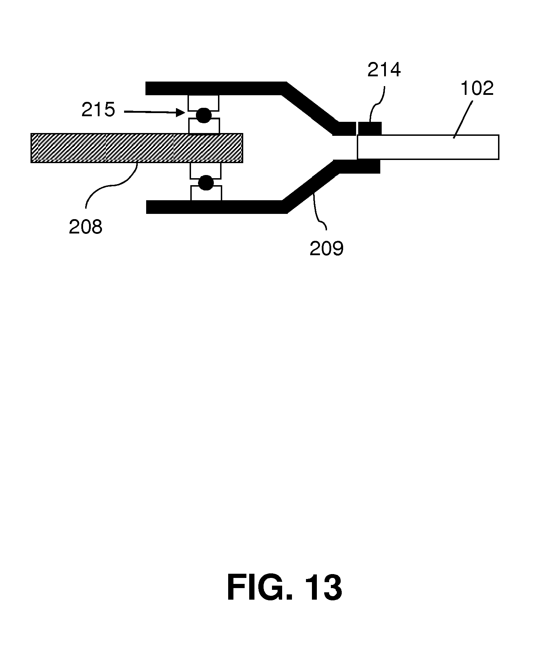

FIG. 13 is a cross sectional view of a spherical bearing which may be used instead of at least one roller bearing 200 described herein above. The spherical bearing shown in FIG. 13 includes a bearing pin 208. The bearing pin 208 may be cooled by flowing cooling water through an interior cavity (not shown). Thus a heat transfer from the bearing to the main frame 401 to which the spherical bearing is attached is reduced. The transport shaft 102 is fixed to a shaft connector 209 concentrically surrounding the bearing pin. The shaft connector 209 includes a fixing member 214 which is provided for fixing the transport shaft 102 to the shaft connector. A spherical bearing 215 is provided between the fixed bearing pin 208 and the outer, rotating shaft connector 209. If heat transfer from the transport shaft 102 to the shaft connector 209 occurs, a thermal expansion of the shaft connector 209 may be tolerated without a risk of blocking the spherical bearing 215. Thus a safe and reliable support of the transport shaft 102 may be provided. By opening the fixing member 214 which may be provided as at least one half-shell, the transport shaft 102 is removed and/or exchanged in a simplified manner.

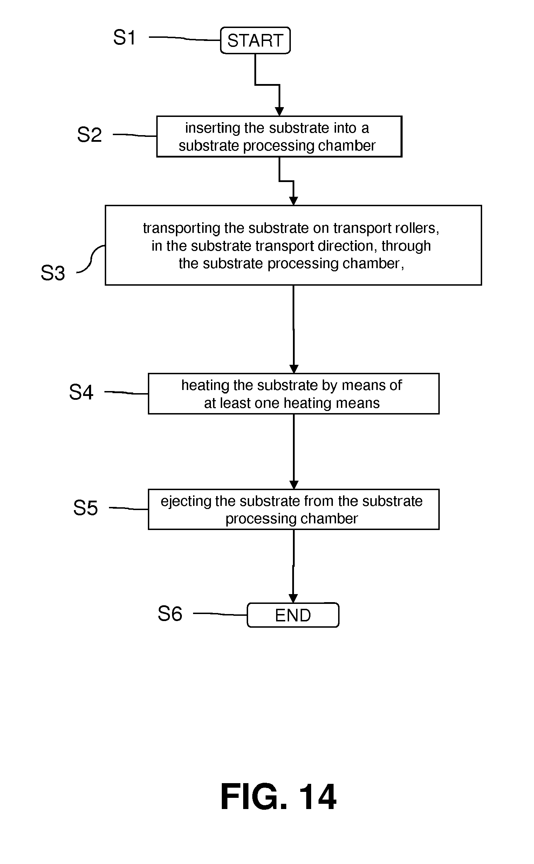

FIG. 14 is a flowchart illustrating a method for transporting a substrate moving in a substrate transport direction, within a substrate processing chamber. The method includes steps S1 to S6.

At a step S1 the procedure is started. Then the procedure advances to a step S2, where the substrate 500 is moved (inserted) into the substrate processing chamber. Then, at a step S3, the substrate is transported on transport rollers in the substrate transport direction, through the substrate processing chamber. The substrate rollers are supported by at least one roller bearing and the transport rollers each have at least one heat conductivity reducing means adapted for reducing a heat transfer from the moving substrate to the roller bearing.

Then the procedure advances to a step S4, where the substrate is heated by means of at least one heating means. After the substrate 500 has been heated by the heating means, or during heating up the substrate 500 to a desired processing temperature, processing of the substrate surface may be provided such as, but not limited to, surface coating, surface activation, surface passivation and other surface-related processes. At a step S5 the substrate is moved out of (ejected from) the substrate processing chamber, and at a step S6 the procedure is ended.

The uniform heating provided by the heating means included in the substrate transport system in accordance with at least one embodiment described above provides both high deposition rates and high quality of deposited films.

The substrate transport system 100 furthermore may be applied to substrate processing chambers where other plasma-enhanced surface modification processes are carried out such as, but not limited to, plasma-enhanced surface activation, plasma-assisted surface passivation, plasma-enhanced etching, etc.

The high temperature transport system of a substrate may thus be applied in any plasma processing system where both a high temperature of the substrate to be processed and a protection of surrounding components from transferred heat is desired.

In light of the above, a plurality of embodiments has been described. For example, according to one embodiment, a substrate transport system adapted for transporting a substrate moving in a substrate transport direction in a processing chamber is provided. The substrate transport system includes a plurality of transport rollers each having a transport shaft and a transport wheel adapted for supporting the moving substrate; and a heating means arranged between the position of the moving substrate and the transport shaft and being adapted for heating the moving substrate. According to an optional modification thereof the system includes at least one heat radiation plate arranged between the heating means and the transport shaft and being adapted for reducing a heat transfer from the heating means to the bearing. The heating means may be provided as a heating plate having openings adapted for the transport wheels to reach through the openings. According to yet further embodiments, which can be combined with any of the other embodiments and modifications above, the heating plate includes at least one heating wire arranged in the plane of the heating plate and around the openings. In addition to that the system may include a cooling plate arranged between the heating means and the transport shaft and being adapted for providing heat isolation between the heating means and the bearing. According to yet another modification at least one bearing adapted for rotatably supporting the transport shaft is provided, wherein the transport rollers are configured with at least one heat conductivity reducing means adapted for reducing a heat transfer from the moving substrate to the bearing. Moreover, the heat conductivity reducing means of the transport roller may include one element of the group consisting of a reduced heat conductivity hub adapted for connecting the transport wheel and the transport shaft; a convex circumferential surface of the transport wheel; heat conductivity reducing apertures in the transport wheel; a radial arm having a low heat conductivity, and any combination thereof. The hub may be a bayonet type connector for connecting the transport wheel and the transport shaft. Furthermore, the hub may have at least three spokes to reduce the heat conductivity from the transport wheel to the transport shaft. According to yet another modification the system further includes a driving means adapted for rotating at least one of the plurality of transport rollers and at least one other of the plurality of transport rollers is coupled to the at least one driven transport roller for rotating the at least one other transport roller. According to yet further embodiments, which can be combined with any of the other embodiments and modifications above, the bearing includes at least two adjacent supporting rollers adapted for rotatably supporting the transport shaft or wherein the bearing includes an inner bearing connected to the fixed bearing side and an outer bearing connected to the transport shaft. According to yet further additional or alternative modifications the at least two adjacent supporting rollers each have a convex-shaped circumferential surface adapted for reducing a heat transfer from the transport shaft to supporting rollers. According to yet further embodiments which can be combined with any one of the embodiments described herein above the heating means includes a first heating area having a first density of heating wires, and at least two second heating areas having a second density of heating wires which is larger than the first density of heating wires. According to yet further additional or alternative modifications the at least two second heating areas having the second density of heating wires are arranged at lateral sides, with respect to the substrate transport direction, of the heating means, and wherein the first heating area having the first density of heating wires is arranged between the two second heating areas. In accordance with yet another embodiment a substrate transport system adapted for transporting a substrate moving in a substrate transport direction in a processing chamber is provided. The substrate transport system includes a plurality of transport rollers each having a transport shaft and a transport wheel and being adapted for supporting the moving substrate; and at least one bearing adapted for rotatably supporting the transport shaft, wherein the transport rollers are configured with at least one heat conductivity reducing means adapted for reducing a heat transfer from the moving substrate to the roller bearing. In accordance with yet another embodiment a method for transporting a substrate moving in a substrate transport direction within a processing chamber, e.g., a plasma processing chamber, is provided. The method includes moving the substrate into the processing chamber; transporting the substrate on transport rollers having a transport shaft and a transport wheel, in the substrate transport direction, through the processing chamber; heating the substrate by means of at least one heating means positioned between the substrate and the transport shaft; and moving the substrate out of the processing chamber. According to yet further embodiments, which can be combined with any of the other embodiments and modifications above a heat transfer from the moving substrate to the bearing is reduced by means of a cooling plate arranged between the heating means and the transport shaft. In addition to that, or alternatively, the heat transfer from the moving substrate to the bearing may be reduced by a heat radiation plate arranged between the heating means and the cooling plate. Furthermore the transport shaft of the transport roller is rotatably supported by at least two adjacent supporting rollers wherein the transport shaft is connected to an outer bearing portion of a bearing. According to yet further embodiments, which can be combined with any of the other embodiments and modifications above the moving substrate is heated by a non-uniform heating intensity with respect to a substrate width being perpendicular to the substrate transport direction.

While the foregoing is directed to embodiments of the invention, other and further embodiments of the invention may be devised without departing from the basic scope thereof, and the scope thereof is determined by the claims that follow.

## Claims

1. A substrate transport system adapted for transporting a substrate moving in a substrate transport direction in a processing chamber, the substrate transport system comprising:
a plurality of transport rollers each having a transport shaft and a transport wheel adapted for supporting the moving substrate; and
a heating means arranged between the position of the moving substrate and the transport shaft and being adapted for heating the moving substrate.

2. The system in accordance with claim 1, further comprising
at least one heat radiation plate arranged between the heating means and the transport shaft and being adapted for reducing a heat transfer from the heating means to the bearing.

3. The system in accordance with any of claims 1 to 2, wherein the heating means is provided as a heating plate comprising openings adapted for the transport wheels to reach through the openings.

4. The system in accordance with claim 3, wherein the heating means comprises at least one heating wire arranged in the plane of the heating means and around the wheel feedthroughs.

5. The system in accordance with any of claims 1 to 4, further comprising a cooling plate arranged between the heating means and the transport shaft and being adapted for providing a heat isolation between the heating means and the bearing.

6. The system in accordance with any of claims 1 to 5, further comprising:
at least one bearing adapted for rotatably supporting the transport shaft, and wherein the transport rollers are configured with at least one heat conductivity reducing means adapted for reducing a heat transfer from the moving substrate to the bearing.

7. The system in accordance with claim 6, wherein the heat conductivity reducing means of the transport roller comprises one element of the group consisting of: a reduced heat conductivity hub adapted for connecting the transport wheel and the transport shaft; a convex circumferential surface of the transport wheel; heat conductivity reducing apertures in the transport wheel; a radial arm having a low heat conductivity, and any combination thereof.

8. The system in accordance with claim 7, wherein the hub is a bayonet type connector for connecting the transport wheel and the transport shaft.

9. The system in accordance with any one of claims 7 to 8, wherein the hub has at least three spokes to reduce the heat conductivity from the transport wheel to the transport shaft.

10. The system in accordance with any one of the preceding claims, wherein the bearing comprises at least two adjacent supporting rollers adapted for rotatably supporting the transport shaft or wherein the bearing comprises an inner bearing connected to the fixed bearing side and an outer bearing connected to the transport shaft.

11. The system in accordance with any one of the preceding claims, wherein the heating means comprises a first heating area having a first density of heating wires, and at least two second heating areas having a second density of heating wires which is larger than the first density of heating wires.

12. A method for transporting a substrate moving in a substrate transport direction within a processing chamber, the method comprising:
moving the substrate into the processing chamber;
transporting the substrate on transport rollers having a transport shaft and a transport wheel, in the substrate transport direction, through the processing chamber;
heating the substrate by means of at least one heating means positioned between the substrate and the transport shaft; and
moving the substrate out of the processing chamber.

13. The method in accordance with claim 12, wherein a heat transfer from the moving substrate to the bearing is reduced by means of a cooling plate arranged between the heating means and the transport shaft.

14. The method in accordance with any one of the claims 12 to 13, wherein a heat transfer from the moving substrate to the bearing is reduced by a heat radiation plate arranged between the heating means and the cooling plate.

15. The method in accordance with any of claims 12 to 14, wherein a heat transfer from the moving substrate to the bearing is reduced by means of at least one element selected from the group consisting of: a reduced heat conductivity hub adapted for connecting the transport wheel and the transport shaft; a convex circumferential surface of the transport wheel; heat conductivity reducing apertures in the transport wheel; a radial arm having a low heat conductivity, and any combination thereof.

16. The method in accordance with any one of the claims 12 to 15, wherein the moving substrate is heated by a non-uniform heating intensity with respect to a substrate width being perpendicular to the substrate transport direction.

## Amended claims

### Amended claims in accordance with Rule 137(2) EPC.

**1.** A substrate transport system (100) adapted for transporting a substrate (500) moving in a substrate transport direction (501) in a processing chamber, the substrate transport system (100) comprising:
a plurality of transport rollers (101) each having a transport shaft (102) and a transport wheel (103) adapted for supporting the moving substrate (500);
a heating means arranged between the position of the moving substrate (500) and the transport shaft (102) and being adapted for heating the moving substrate (500); and
at least one heat radiation plate (400) arranged between the heating means and the transport shaft (102) and being adapted for reducing a heat transfer from the heating means to a bearing of the transport shaft (102).

**2.** The system (100) in accordance with claim 1, wherein the heating means is provided as a heating plate (300) comprising openings (105) adapted for the transport wheels (103) to reach through the openings (105).

**3.** The system (100) in accordance with claim 2 or 3, wherein the heating means comprises at least one heating wire (301) arranged in the plane of the heating means and around the openings (105).

**4.** The system (100) in accordance with any of claims 1 to 3, further comprising a cooling plate (207) arranged between the heating means and the transport shaft (102) and being adapted for providing a heat isolation between the heating means and the bearing.

**5.** The system (100) in accordance with any of claims 1 to 4, further comprising:
at least one bearing adapted for rotatably supporting the transport shaft (102), and wherein the transport rollers are configured with at least one heat conductivity reducing means adapted for reducing a heat transfer from the moving substrate (500) to the bearing.

**6.** The system (100) in accordance with claim 5, wherein the heat conductivity reducing means of the transport roller comprises one element of the group consisting of: a reduced heat conductivity hub adapted for connecting the transport wheel (103) and the transport shaft (102); a convex circumferential surface of the transport wheel (103); heat conductivity reducing apertures (204) in the transport wheel (103); a radial arm having a low heat conductivity, and any combination thereof.

**7.** The system (100) in accordance with claim 5, wherein the heat conductivity reducing means comprises a reduced heat conductivity hub provided as a bayonet type connector for connecting the transport wheel (103) and the transport shaft (102).

**8.** The system (100) in accordance with any one of claims 6 to 7, wherein the hub has at least three spokes to reduce the heat conductivity from the transport wheel (103) to the transport shaft (102).

**9.** The system (100) in accordance with any one of the preceding claims, wherein the bearing comprises at least two adjacent supporting rollers (201, 202) adapted for rotatably supporting the transport shaft (102) or wherein the bearing comprises an inner bearing connected to the fixed bearing side and an outer bearing connected to the transport shaft (102).

**10.** The system (100) in accordance with any one of the preceding claims, wherein the heating means comprises a first heating area (302) having a first density of heating wires, and at least two second heating areas (303) having a second density of heating wires which is larger than the first density of heating wires.

**11.** A method for transporting a substrate (500) moving in a substrate transport direction (501) within a processing chamber, the method comprising:
moving the substrate (500) into the processing chamber;
transporting the substrate (500) on transport rollers each having a transport shaft (102) and a transport wheel (103), in the substrate transport direction (501), through the processing chamber;
heating the substrate (500) by means of at least one heating means positioned between the substrate (500) and the transport shaft (102); and
moving the substrate (500) out of the processing chamber,
wherein a heat transfer from the moving substrate (500) to a bearing of the transport shaft (102) is reduced by a heat radiation plate arranged between the heating means and the transport shaft (102).

**12.** The method in accordance with claim 13, wherein a heat transfer from the moving substrate (500) to a bearing of the transport shaft (102) is reduced by means of a cooling plate arranged between the heating means and the transport shaft (102).

**13.** The method in accordance with claim 11 or 12, wherein a heat transfer from the moving substrate (500) to the bearing is reduced by means of at least one element selected from the group consisting of: a reduced heat conductivity hub adapted for connecting the transport wheel (103) and the transport shaft (102); a convex circumferential surface of the transport wheel (103); heat conductivity reducing apertures (204) in the transport wheel (103); a radial arm having a low heat conductivity, and any combination thereof.

**14.** The method in accordance with any one of the claims 12 to 13, wherein the moving substrate (500) is heated by a non-uniform heating intensity with respect to a substrate width being perpendicular to the substrate transport direction (501).
